# EUROPÄISCHE PATENTSCHRIFT

(11) **EP 4 160 237 B1**
(45) Veröffentlichungstag und Bekanntmachung des Hinweises auf die Patenterteilung: **06.08.2025**
(21) Anmeldenummer: 22193202.3
(22) Anmeldetag: 31.08.2022
(51) Int. Cl.: G01R 31/71

(54) **VORRICHTUNG UND VERFAHREN ZUR ERKENNUNG EINES DEFEKTES EINES LÖTKONTAKTS**
DEVICE AND METHOD FOR DETECTING A DEFECT OF A SOLDER CONTACT
APPAREIL ET PROCÉDÉ DE DÉTECTION DE DÉFAUT DE CONTACT DE SOUDURE

(30) Priorität: 30.09.2021 DE 102021210981
(43) Veröffentlichungstag der Anmeldung: 05.04.2023
(73) Patentinhaber: BSH Hausgeräte GmbH, 81739 München (DE)
(72) Erfinder: Köppl, Magnus, 93093 Donaustauf (DE); Reitner, Josef, 93093 Donaustauf (DE); Stark, Alexander-Manuel, 93049 Regensburg (DE)

(56) Entgegenhaltungen:
- KR-B1- 101 024 074
- US-A1- 2008 144 243
- OBRZUT JAN: "Interconnection continuity test for packaged functional modules", THE 1998 INTERNATIONAL CONFERENCE ON CHARACTERIZATION AND METROLOGY FOR ULSI TECHNOLOGY, 27 March 1998 (1998-03-27), pages 607 - 609, XP093021572, ISBN: 978-1-56396-753-5, DOI: 10.1063/1.56914
- VOLTLOG: "Best Technique For Soldering & Inspecting BGA Chips - Voltlog #352", 24 February 2021 (2021-02-24), XP093021718, Retrieved from the Internet <URL:https://www.youtube.com/watch?v=15RFI9wKHq8> [retrieved on 20230207]

## Beschreibung

Die Erfindung betrifft eine Vorrichtung und ein entsprechendes Verfahren zur Erkennung eines Defektes eines Lötkontaktes, insbesondere einer Lotperle, einer BGA (Ball Grid Array) Komponente.

Ein elektronisches und/oder elektrisches Gerät kann eine Leiterplatte mit ein oder mehreren BGA-Komponenten aufweisen. Dabei ist eine BGA-Komponente über eine Vielzahl, insbesondere über eine Matrix, von Lötkontaktes (insbesondere Lotperlen) mit entsprechenden elektrischen Kontakten auf der Leiterplatte elektrisch leitend verbunden.

Während des Betriebs des Geräts kann es z.B. aufgrund von mechanischen Belastungen zu einem Defekt von ein oder mehreren Lötkontakten einer BGA-Komponente kommen, wodurch die Funktion des Geräts beeinträchtigt werden kann. Zur Erkennung der ein oder mehreren defekten Lötkontakte kann eine relativ aufwändige Funktionsprüfung des Geräts durchgeführt werden, die Hinweise darauf geben kann, welche ein oder mehreren Lötkontakte einen Defekt aufweisen. Alternativ oder ergänzend kann ein relativ aufwändiger Schliff durch die Kugelmatrix angefertigt und ausgewertet werden. Alternativ oder ergänzend kann anstelle der eigentlichen BGA-Komponente eine spezielle Test-Komponente auf der Leiterplatte angeordnet werden, um den Verschleiß der Lötkontakte aufgrund von mechanischer Belastung überwachen zu können.

OBRZUT JAN: "Interconnection continuity test for packaged functional modules", THE 1998 INTERNATIONAL CONFERENCE ON CHARACTERIZATION AND METROLOGY FOR ULSI TECHNOLOGY, (1998-03-27), Seiten 607-609, beschreibt ein Verfahren zum Testen von Verbindungen eines ESD geschützten elektronischen Moduls. US 2008/0144243 A1 beschreibt ein Verfahren zur Erkennung von Fehlern an Lötkontakten. Voltlog: "Best Technique For Soldering & Inspecting BGA ChipsVoltlog #352", (2021-02-24). URL:https://www.youtube.com/watch?v=15RFI9wKHq8 ist ein Video, in dem ein Testverfahren zum Testen einer BGA Komponente gezeigt wird. KR 101 024 074 B1 beschreibt ein Testverfahren für eine Multichip-Anordnung.

Die Lokalisierung eines defekten Lötkontaktes ist somit typischerweise mit einem relativ hohen Aufwand verbunden. Das vorliegende Dokument befasst sich mit der technischen Aufgabe, eine effiziente, zuverlässige und zerstörungsfreie Lokalisierung eines defekten Lötkontaktes einer BGA-Komponente zu ermöglichen.

Die Aufgabe wird durch den Gegenstand der unabhängigen Patentansprüche gelöst. Vorteilhafte Ausführungsformen sind insbesondere in den abhängigen Patentansprüchen definiert, in nachfolgender Beschreibung beschrieben oder in der beigefügten Zeichnung dargestellt.

Gemäß einem Aspekt der Erfindung wird eine Testvorrichtung zur Überprüfung eines Lötkontaktes (insbesondere einer Lotperle) einer Ball Grid Array (BGA) Komponente beschrieben. Der Lötkontakt kann auf Englisch als "Ball" der BGA-Komponente bezeichnet werden. Die BGA-Komponente kann auf einer Leiterplatte angeordnet sein. Dabei kann der Lötkontakt mit einem entsprechenden Kontakt der Leiterplatte elektrisch leitend verbunden sein. Die BGA-Komponente kann eine Anordnung, insbesondere eine Matrix, von Lötkontakten aufweisen. Beispielsweise kann die BGA-Komponente NxM Lötkontakte aufweisen, z.B. mit N und/oder M größer als 2, oder größer als 4, oder größer als 10. Die Testvorrichtung ist eingerichtet, mehrere, insbesondere alle, Lötkontakte der BGA-Komponente zu überprüfen. Die Überprüfung kann dabei während des Betriebs der BGA-Komponente innerhalb eines elektrischen und/oder elektronischen Geräts (z.B. innerhalb eines Hausgeräts) erfolgen.

Der zu überprüfende Lötkontakt ist über eine interne Diode der BGA-Komponente mit einem Referenzpotential verbunden. Das Referenzpotential kann Masse oder die Betriebsspannung (z.B. 12V oder weniger, oder 5V oder weniger) der BGA-Komponente sein. Insbesondere ist die Mehrzahl von Lötkontakten jeweils über eine interne Diode mit dem Referenzpotential verbunden. Ferner weist die BGA-Komponente zumindest einen Referenz-Lötkontakt auf, der ausgebildet ist, die BGA-Komponente (direkt) mit dem Referenzpotential zu verbinden. Insbesondere kann die BGA-Komponente einen ersten Referenz-Lötkontakt aufweisen, der die BGA-Komponente (direkt) mit einem ersten Referenzpotential (z.B. Masse) verbindet. Des Weiteren kann die BGA-Komponente einen zweiten Referenz-Lötkontakt aufweisen, der die BGA-Komponente (direkt) mit einem zweiten Referenzpotential (z.B. der Betriebsspannung) verbindet.

Die mehreren Lötkontakte der BGA-Komponente können somit jeweils über zumindest eine (sperrende) interne Diode mit zumindest einem Referenzpotential elektrisch leitend gekoppelt sein. Die interne Diode kann dabei als Überspannungsschutz (in Bezug auf ESD, elektrostatische Entladung) bereitgestellt werden. Die jeweilige interne Diode kann sperrend sein, wenn das Spannungspotential an dem Lötkontakt zwischen dem ersten Referenzpotential (insbesondere Masse) und dem zweiten Referenzpotential (insbesondere der Betriebsspannung) liegt. Andererseits kann zumindest eine der internen Dioden leitend werden, wenn das Spannungspotential an dem Lötkontakt über dem zweiten Referenzpotential oder unter dem ersten Referenzpotential liegt.

Die Testvorrichtung ist eingerichtet, einen Messwert des elektrischen Widerstands der Verbindungstrecke von einem Messpunkt über den zu überprüfenden Lötkontakt und über die interne Diode (des zu überprüfenden Lötkontaktes) zu dem Referenzpotential zu ermitteln. Die Testvorrichtung kann insbesondere ausgebildet sein, den Messwert des Widerstands während des Betriebs der BGA-Komponente innerhalb eines elektrischen und/oder elektronischen Geräts zu ermitteln. Es kann somit eine Überprüfung des Zustands des zu überprüfenden Lötkontakts während des Betriebs der BGA-Komponente erfolgen.

Des Weiteren ist die Testvorrichtung eingerichtet, auf Basis des Messwertes zu bestimmen, ob der zu überprüfende Lötkontakt einen Defekt aufweist oder nicht. Die Testvorrichtung kann insbesondere eingerichtet sein, zu ermitteln, ob der ermittelte Messwert des Widerstands größer als oder kleiner als ein vordefinierter Widerstands-Schwellenwert ist. Der Widerstands-Schwellenwert kann z.B. größer als 1kΩ und/oder kleiner als 10MΩ sein. Es kann dann basierend auf dem Vergleich bestimmt werden, ob der zu überprüfende Lötkontakt einen Defekt aufweist oder nicht. Insbesondere kann bestimmt werden, dass der zu überprüfende Lötkontakt einen Defekt aufweist, wenn ermittelt wird, dass der Messwert des Widerstands größer als der Widerstands-Schwellenwert ist. Andererseits kann bestimmt werden, dass der zu überprüfende Lötkontakt keinen Defekt aufweist, wenn ermittelt wird, dass der Messwert des Widerstands kleiner als der Widerstands-Schwellenwert ist.

Die Testvorrichtung kann eingerichtet sein, den Widerstands-Schwellenwert (für den zu überprüfenden Lötkontakt) im Vorfeld zu ermitteln. Beispielsweise kann ein Messwert des elektrischen Widerstands für einen intakten Lötkontakt ermittelt und als Referenzwert verwendet werden. Zur Überprüfung des Lötkontakts (z.B. während des Betriebs der BGA-Komponente), kann dann der Referenzwert oder ein davon abgeleiteter Wert als Widerstands-Schwellenwert verwendet werden. So kann in besonders zuverlässiger Weise ein Defekt eines Lötkontakts detektiert werden.

Es wird somit eine Testvorrichtung beschrieben, die ausgebildet ist, die interne (Anschluss-) Diode eines Lötkontakts dazu zu verwenden, den Zustand des Lötkontaktes (die z.B. die Funktion eines Überspannungsschutzes aufweist) zu überprüfen. So kann in effizienter und zuverlässiger Weise ein defekter Lötkontakt erkannt werden.

Wie bereits oben dargelegt, umfasst die BGA-Komponente einen Referenz-Lötkontakt, der, insbesondere direkt, mit dem Referenzpotential (außerhalb der BGA-Komponente) verbunden ist. Die Verbindungstrecke kann sich dann von dem Messpunkt über den zu überprüfenden Lötkontakt, über die interne Diode und über den Referenz-Lötkontakt zu dem Referenzpotential erstrecken. Durch die Verwendung eines Referenz-Lötkontaktes kann die Anbindung des Referenzpotentials an die BGA-Komponente in effizienter Weise bewirkt werden.

Die Testvorrichtung ist eingerichtet, Referenzinformation dahingehend zu ermitteln, ob der Referenz-Lötkontakt einen Defekt aufweist oder nicht. Es wird dann in besonders zuverlässiger Weise unter Berücksichtigung der Referenzinformation bestimmt, ob der zu überprüfende Lötkontakt einen Defekt aufweist oder nicht. Insbesondere wird bei der Auswertung des ermittelten Messwertes berücksichtigt, ob der Referenz-Lötkontakt einen Defekt aufweist oder nicht. So kann die Zuverlässigkeit der Erkennung eines defekten Lötkontaktes weiter erhöht werden.

Der zu überprüfende Lötkontakt kann über die interne Diode der BGA-Komponente mit dem ersten Referenzpotential, insbesondere mit Masse, oder mit dem zweiten Referenzpotential, insbesondere mit der Betriebsspannung der BGA-Komponente, verbunden sein. Die Testvorrichtung kann eingerichtet sein, einen ersten Messwert des elektrischen Widerstands einer ersten Verbindungstrecke von dem Messpunkt über den zu überprüfenden Lötkontakt zu dem ersten Referenzpotential zu ermitteln. Des Weiteren kann ein zweiter Messwert des elektrischen Widerstands einer zweiten Verbindungstrecke von dem Messpunkt über den zu überprüfenden Lötkontakt zu dem zweiten Referenzpotential ermittelt werden. Zu diesem Zweck können an dem Messpunkt spezifische Spannungspotentiale angelegt werden. Zur Ermittlung des ersten Messwertes kann z.B. ein erstes Spannungspotential an dem Messpunkt angelegt werden, durch das die Diode relativ zu dem ersten Referenzpotential leitend wird. Andererseits kann zur Ermittlung des zweiten Messwertes ein zweites Spannungspotential an dem Messpunkt angelegt werden, durch das die Diode relativ zu dem zweiten Referenzpotential leitend wird.

Es kann dann in besonders zuverlässiger Weise auf Basis des ersten Messwertes und auf Basis des zweiten Messwertes bestimmt werden, ob der zu überprüfende Lötkontakt einen Defekt aufweist oder nicht. Die Testvorrichtung kann insbesondere eingerichtet sein, zu bestimmen, dass der zu überprüfende Lötkontakt einen Defekt aufweist, wenn der erste Messwert und der zweite Messwert jeweils größer als der Widerstands-Schwellenwert sind. Ferner kann die Testvorrichtung eingerichtet sein, zu bestimmen, dass der zu überprüfende Lötkontakt keinen Defekt aufweist, wenn der erste Messwert oder der zweite Messwert (d.h. zumindest einer der Messwerte) kleiner als der Widerstands-Schwellenwert sind.

Wie bereits dargelegt, umfasst die BGA-Komponente typischerweise eine Mehrzahl von Lötkontakten (die z.B. in einer Matrix angeordnet sind). Die Lötkontakte können jeweils über eine (ggf. dedizierte) interne Diode der BGA-Komponente mit dem Referenzpotential verbunden sein.

Die Test-Vorrichtung ist eingerichtet, eine Mehrzahl von Messwerten des elektrischen Widerstands einer entsprechenden Mehrzahl von Verbindungstrecken zu ermitteln. Dabei verläuft die Verbindungsstrecke für einen zu überprüfenden Lötkontakt von einem jeweiligen Messpunkt über den jeweils zu überprüfenden Lötkontakt und über die jeweilige interne Diode zu dem Referenzpotential. Es können somit für die unterschiedlichen Lötkontakte an den jeweiligen Messpunkten Messwerte des elektrischen Widerstands der jeweiligen Verbindungstrecke zu dem Referenzpotential ermittelt werden.

Es kann dann in besonders präziser Weise auf Basis der Mehrzahl von Messwerten bestimmt werden, ob ein oder mehrere der Mehrzahl von Lötkontakten, insbesondere welche ein oder mehreren der Mehrzahl von Lötkontakten, einen Defekt aufweisen.

Die Testvorrichtung ist ferner eingerichtet, auf Basis der Mehrzahl von Messwerten Referenzinformation dahingehend zu ermitteln, ob der Referenz-Lötkontakt (an dem das Referenzpotential angebunden ist) einen Defekt aufweist oder nicht. Die Testvorrichtung kann insbesondere eingerichtet sein, auf Basis der Mehrzahl von Messwerten als Referenzinformation zu bestimmen, dass der Referenz-Lötkontakt defekt ist, wenn alle Messwerte der Mehrzahl von Messwerten größer als der Widerstands-Schwellenwert sind. Des Weiteren kann die Testvorrichtung eingerichtet sein, auf Basis der Mehrzahl von Messwerten als Referenzinformation zu bestimmen, dass der Referenz-Lötkontakt nicht defekt ist, wenn zumindest ein Messwert der Mehrzahl von Messwerten kleiner als der Widerstands-Schwellenwert ist. So kann die Referenzinformation in Bezug auf den Referenz-Lötkontakt in besonders effizienter und zuverlässiger Weise ermittelt werden.

Die interne Diode zwischen einem zu überprüfenden Lötkontakt und dem Referenzpotential kann ggf. in dem Normalbetrieb der BGA-Komponente in Sperrrichtung betrieben werden. Die Testvorrichtung kann ausgebildet sein, ein Spannungspotential an dem Messpunkt (zur Überprüfung des jeweiligen Lötkontaktes) anzulegen, um zu bewirken, dass die interne Diode auf der Verbindungstrecke von dem Messpunkt über den zu überprüfenden Lötkontakt und über die interne Diode zu dem Referenzpotential in einem Testbetrieb für die Ermittlung des Messwertes des Widerstands in Durchlassrichtung betrieben wird. So kann in besonders zuverlässiger Weise ein Messwert zur Überprüfung eines Lötkontaktes bereitgestellt werden

Gemäß einem weiteren Aspekt wird ein Verfahren zur Überprüfung eines Lötkontaktes (insbesondere einer Lotperle oder eines "Balls") einer BGA-Komponente beschrieben. Die BGA-Komponente ist auf einer Leiterplatte und ggf. mit der Leiterplatte innerhalb eines elektrischen und/oder elektronischen Geräts (insbesondere innerhalb eines Hausgeräts) angeordnet. Der zu überprüfende Lötkontakt ist über eine interne Diode der BGA-Komponente mit einem Referenzpotential (z.B. mit Masse oder mit der Betriebsspannung) verbunden.

Das Verfahren umfasst das Ermitteln eines Messwertes des elektrischen Widerstands der Verbindungstrecke von einem Messpunkt (an dem ein bestimmtes Spannungspotential angelegt wird) über den zu überprüfenden Lötkontakt und über die interne Diode zu dem Referenzpotential. Dabei kann zur Ermittlung des Messwertes des elektrischen Widerstands ein Spannungspotential an dem Messpunkt angelegt werden, durch das bei intaktem Lötkontakt bewirkt wird, dass die interne Diode in Durchflussrichtung betrieben wird.

Des Weiteren umfasst das Verfahren das Ermitteln, auf Basis der Mehrzahl von Messwerten, Referenzinformation dahingehend, ob der Referenz-Lötkontakt (222) einen Defekt aufweist oder nicht; und das Bestimmen (302), auf Basis der Mehrzahl von Messwerten und unter Berücksichtigung der Referenzinformation, ob ein oder mehrere der Mehrzahl von Lötkontakten (121, 223) einen Defekt aufweisen.

Es ist zu beachten, dass jegliche Aspekte der in diesem Dokument beschriebenen Vorrichtung und des in diesem Dokument beschriebenen Verfahrens in vielfältiger Weise miteinander kombiniert werden können. Insbesondere können die Merkmale der Patentansprüche in vielfältiger Weise miteinander kombiniert werden.

Im Weiteren wird die Erfindung anhand von in der beigefügten Zeichnung dargestellten Ausführungsbeispielen näher beschrieben. Dabei zeigen
Figuren 1a und 1b unterschiedliche Ansichten einer Leiterplatte mit einer BGA-Komponente;
Figur 2a einen beispielhaften Lötkontakt;
Figur 2b eine beispielhafte Testvorrichtung zur Überprüfung eines Lötkontaktes;
Figur 2c eine beispielhafte Testvorrichtung zur Lokalisierung eines defekten Lötkontaktes einer BGA-Komponente; und
Figur 3 ein Ablaufdiagramm eines beispielhaften Verfahrens zur Lokalisierung eines
   defekten Lötkontaktes einer BGA-Komponente.

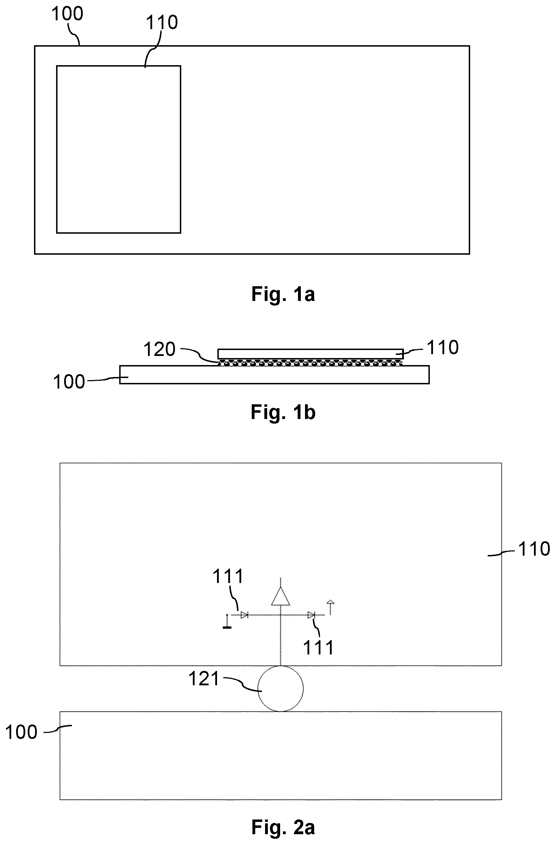

Wie eingangs dargelegt, befasst sich das vorliegende Dokument mit der effizienten und zuverlässigen Lokalisierung eines defekten Lötkontaktes einer BGA-Komponente. In diesem Zusammenhang zeigen die Figuren 1a und 1b eine Leiterplatte 100 eines elektrischen und/oder elektronischen Geräts, die mit einer BGA-Komponente 110 bestückt ist. Die BGA-Komponente 110 ist über eine Anordnung 120, insbesondere über eine Matrix, von Lötkontakten mit einer entsprechenden Anordnung von Kontaktstellen der Leiterplatte 100 elektrisch leitend verbunden. Dabei können die einzelnen Lötkontakte über Lötzinn mit den entsprechenden Kontaktstellen elektrisch leitend und mechanisch verbunden sein. Insbesondere können die einzelnen Lötkontakte jeweils Lötzinn aufweisen, der zum Verlöten mit den entsprechenden Kontaktstellen verwendet werden kann. Die einzelnen Lötkontakte können z.B. als Lotkugeln oder als Lotperlen ausgebildet sein.

Während des Betriebs des Geräts, in dem die Leiterplatte 100 angeordnet ist, kann es z.B. aufgrund einer mechanischen Belastung dazu kommen, dass eine elektrisch leitende Verbindung zwischen einem Lötkontakt und einer entsprechenden Kontaktstelle beeinträchtigt wird. Beispielsweise kann sich ein Riss an der Lötstelle zwischen einem Lötkontakt und der entsprechenden Kontaktstelle bilden. Ggf. kann die Lötstelle brechen. Die Beeinträchtigung einer Verbindung zwischen einem Lötkontakt und einer entsprechenden Kontaktstelle kann dazu führen, dass die Funktionalität des Geräts beeinträchtigt wird. In diesem Dokument werden eine Vorrichtung und ein entsprechendes Verfahren beschrieben, die eine effiziente und zuverlässige Lokalisierung eines defekten Lötkontaktes (d.h. auch einer defekten Verbindung zwischen einem Lötkontakt und einer entsprechenden Kontaktstelle auf einer Leiterplatte 100) ermöglichen.

Fig. 2a zeigt einen beispielhaften Lötkontakt 121 einer BGA-Komponente 110. Der Lötkontakt 121 ist elektrisch leitend mit ein oder mehreren funktionalen Schaltungselementen innerhalb der BGA-Komponente 110 verbunden (dargestellt durch das Dreieck in Fig. 2a). Darüber hinaus ist der Lötkontakt 121 typischerweise über eine (Anschluss-) Diode 111 mit Masse oder über eine (Anschluss-) Diode 111 mit der Betriebsspannung (VCC) der BGA-Komponente 110 verbunden. Die Diode 111 ist dabei jeweils in Sperrrichtung angeordnet, sodass der Lötkontakt 121 über eine sperrende Diode 111 mit Masse oder über eine sperrende Diode 111 mit der Betriebsspannung gekoppelt ist.

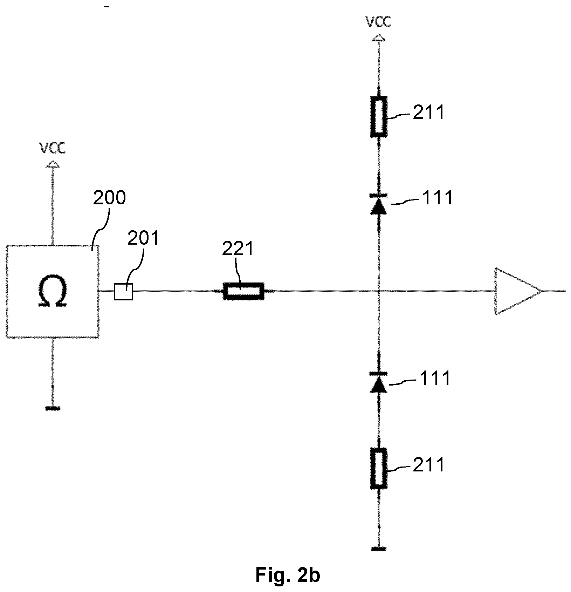

Fig. 2b zeigt eine beispielhafte Testvorrichtung 200 zur Überprüfung eines Lötkontaktes 121. Der Lötkontakt 121 wird in Fig. 2b durch einen entsprechenden Kontaktwiderstand 221 repräsentiert. Ferner veranschaulicht Fig. 2b wie der Lötkontakt 121 (mit dem entsprechenden Kontaktwiderstand 221) über eine (Anschluss-) Diode 111 und über einen Leitungswiderstand 211 mit Masse oder mit der Betriebsspannung (VCC) gekoppelt ist.

Die Testvorrichtung 200 kann eingerichtet sein, einen Messwert des elektrischen und/oder ohmschen Widerstands der Verbindungsstrecke von dem Messpunkt 201, über den Lötkontakt 121 und über eine (Anschluss-) Diode 111, zu Masse oder zu der Betriebsspannung zu ermitteln. Dabei kann die Testvorrichtung 200 eingerichtet sein, zu bewirken, dass sich die Diode 111 für die Messung des Widerstands in Flussrichtung befindet. Dies kann durch eine entsprechende Einstellung des Spannungspotentials an dem Messpunkt 201 bewirkt werden. Durch den Betrieb der (Anschluss-) Diode 111 in Flussrichtung kann bewirkt werden, dass der Messwert des Widerstands bei Vorliegen eines intakten Lötkontakts 121 relativ niedrig sein sollte (z.B. kleiner als 1kΩ). Andererseits deutet ein relativ hoher Messwert des Widerstands (z.B. gleich wie oder größer als 1MΩ) auf einen defekten Lötkontakt 121 hin.

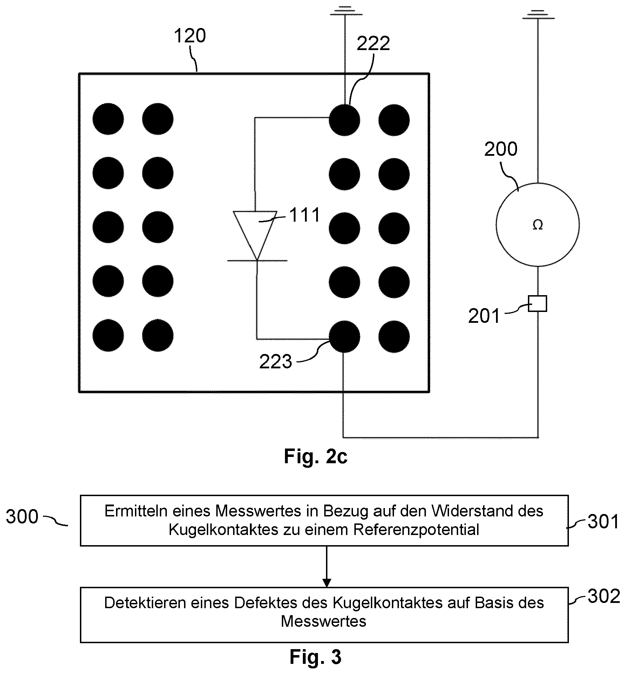

Fig. 2c zeigt eine beispielhafte Anordnung 120 von Lötkontakten 121, 222, 223. In dem dargestellten Beispiel ist der zu überprüfende (erste) Lötkontakt 223 über eine Diode 111 mit dem auf Masse liegenden Referenz-Lötkontakt 222 verbunden. Die Testvorrichtung 200 ist eingerichtet, den Messwert des Widerstands der Verbindungsstrecke zwischen dem Messpunkt 201 und Masse zu erfassen. Zu diesem Zweck kann an den Messpunkt 201 ein Spannungspotential angelegt werden, durch das bewirkt wird, dass die Diode 111 leitend wird. Die Verbindungsstrecke umfasst den ersten Lötkontakt 223, die (in Flussrichtung betriebene) Diode 111 und den Referenz-Lötkontakt 222. Auf Basis des Messwertes des Widerstands dieser Verbindungsstrecke kann überprüft werden, ob der erste und/oder der Referenz-Lötkontakt 223, 222 einen Defekt aufweisen.

In entsprechender Weise kann für eine Mehrzahl von zu überprüfenden (ersten) Lötkontakten 223 jeweils ein Messwert des Widerstands ermittelt werden. Es kann somit für eine Vielzahl von unterschiedlichen (ersten) Lötkontakten 223 jeweils ein Messwert des Widerstands der Verbindungsstrecke von dem Messpunkt 201 über dien jeweiligen (ersten) Lötkontakt 223, über den einheitlichen Referenz-Lötkontakt 222 zu Masse ermittelt werden. Der Referenz-Lötkontakt 222 ist ausgebildet, die BGA-Komponente 110 allgemein mit einem Referenzpotential (z.B. Masse oder der Betriebsspannung) zu verbinden.

Aus der Vielzahl von Messwerten des Widerstands der jeweiligen Verbindungsstrecke kann folgendes geschlossen werden:
- wenn alle Messwerte gleich wie oder größer als der vordefinierte Widerstands-Schwellenwert (z.B. von 1MΩ) sind, dann kann daraus geschlossen werden, dass der einheitliche Referenz-Lötkontakt 222 einen Defekt aufweist;
- wenn zumindest ein Messwert kleiner als der Widerstands-Schwellenwert ist, dann kann daraus geschlossen werden, dass der Referenz-Lötkontakt 222 keinen Defekt aufweist; und/oder
- wenn ein oder mehrere Messwerte (aber nicht alle Messwerte) gleich wie oder größer als der Widerstands-Schwellenwert sind, dann kann daraus geschlossen werden, dass der mit dem jeweiligen Messwert zu überprüfende Lötkontakt 223 einen Defekt aufweist.

Wie eingangs dargelegt, sollten alle Lötkontakte 121, 222, 223 einer BGA-Komponente 110 über jeweilige Lötstellen einen elektrisch leitenden Kontakt zu der Leiterplatte 100 aufweisen, um die volle Funktionsfähigkeit der BGA-Komponente 110 gewährleisten zu können. Es kann jedoch vorkommen, dass eine Lötstelle reißt und dadurch eine elektrische Verbindung nicht mehr sichergestellt werden kann.

Um die elektrische Verbindung während eines Tests einer Leiterplatte 100 oder direkt in einem Gerät zu überwachen, kann der elektrische Widerstand der Diode 111 in der BGA-Komponente 110 über eine zu testende BGA-Lötstelle 223 zu Ground oder zu VCC gemessen werden. Kommt es hierbei zu einer hochohmigen Messung am Ohmmeter 200 (d.h. an der Testvorrichtung), kann darauf geschlossen werden, dass die zu testende BGA-Lötstelle 223 gerissen ist. Mit der in diesem Dokument beschriebenen Methode können BGA-Komponenten 110 im Test charakterisiert und/oder es kann ein spezifischer Ausfallzeitpunkt während des Betriebs ermittelt werden. Ferner kann eine BGA-Komponente 110 permanent bzw. wiederholt während des Betriebs in einem Gerät überwacht werden.

Fig. 3 zeigt ein Ablaufdiagramm eines (ggf. Computer-implementierten) Verfahrens 300 zur Überprüfung eines Lötkontaktes 121, 223 (insbesondere einer Lotperle bzw. eines "Balls") einer BGA-Komponente 110. Der zu überprüfende Lötkontakt 121, 223 ist dabei über eine interne Diode 111 der BGA-Komponente 110 mit einem Referenzpotential (z.B. Masse oder der Betriebsspannung VCC) verbunden. Dabei kann die interne Diode 111 im Normalbetrieb sperrend sein.

Das Verfahren 300 umfasst das Ermitteln 301 eines Messwertes des elektrischen Widerstands der Verbindungstrecke von einem Messpunkt 201 über den zu überprüfenden Lötkontakt 121, 223 und über die interne Diode 111 zu dem Referenzpotential. Zu diesem Zweck kann an dem Messpunkt 201 ein Spannungspotential angelegt werden, durch das bewirkt wird, dass die interne Diode 111 in Durchflussrichtung betrieben wird.

Das Verfahren 300 umfasst ferner das Bestimmen 302, auf Basis des Messwertes, ob der zu überprüfende Lötkontakt 121, 223 einen Defekt aufweist oder nicht. Dabei kann ein Messwert, der größer als ein bestimmter Widerstands-Schwellenwert ist, ein Hinweis auf einen defekten Lötkontakt 121, 223 sein. Andererseits kann ein Messwert, der kleiner als der bestimmte Widerstands-Schwellenwert ist, ein Hinweis auf einen fehlerfreien Lötkontakt 121, 223 sein.

Durch die in diesem Dokument beschriebenen Maßnahmen können die Lötkontakte 121, 222, 223 einer BGA-Komponente 110 in effizienter und zuverlässiger Weise getestet und/oder überwacht werden. So kann die Zuverlässigkeit einer Leiterplatte 100 mit einer BGA-Komponente 110 erhöht werden.

Die vorliegende Erfindung ist nicht auf die gezeigten Ausführungsbeispiele beschränkt. Insbesondere ist zu beachten, dass die Beschreibung und die Figuren nur das Prinzip der vorgeschlagenen Vorrichtung und des vorgeschlagenen Verfahrens veranschaulichen sollen.

## Patentansprüche

1. System, das umfasst,
- eine auf einer Leiterplatte (100) angeordnete Ball Grid Array, kurz BGA, Komponente (110); wobei die BGA-Komponente (110) einen Referenz-Lötkontakt (222) umfasst, der mit einem Referenzpotential verbunden ist; wobei die BGA-Komponente (110) eine Mehrzahl von Lötkontakten (121, 223) umfasst; wobei die Lötkontakte (121, 223) jeweils über eine interne Diode (111) der BGA-Komponente (110) und über den Referenz-Lötkontakt (222) mit dem Referenzpotential verbunden sind; und
- eine Testvorrichtung (200) zur Überprüfung eines Lötkontaktes (121, 223) der BGA Komponente (110); wobei die Testvorrichtung (200) eingerichtet ist,
- eine Mehrzahl von Messwerten eines elektrischen Widerstands einer entsprechenden Mehrzahl von Verbindungstrecken für die entsprechende Mehrzahl von Lötkontakten (121, 223) zu ermitteln; wobei die Verbindungsstrecke für einen zu überprüfenden Lötkontakt (121, 223) von einem jeweiligen Messpunkt (201) über den jeweils zu überprüfenden Lötkontakt (121, 223), über die jeweilige interne Diode (111) und über den Referenz-Lötkontakt (222) zu dem Referenzpotential verläuft;
- auf Basis der Mehrzahl von Messwerten Referenzinformation dahingehend zu ermitteln, ob der Referenz-Lötkontakt (222) einen Defekt aufweist oder nicht; und
- auf Basis der Mehrzahl von Messwerten und unter Berücksichtigung der Referenzinformation zu bestimmen, ob ein oder mehrere der Mehrzahl von Lötkontakten (121, 223) einen Defekt aufweisen.

2. System gemäß Anspruch 1, wobei die Testvorrichtung (200) eingerichtet ist,
- zu ermitteln, ob der ermittelte Messwert des Widerstands für einen zu überprüfenden Lötkontakt (121, 223) größer als oder kleiner als ein vordefinierter Widerstands-Schwellenwert ist; und
- basierend darauf zu bestimmen, ob der zu überprüfende Lötkontakt (121, 223) einen Defekt aufweist oder nicht.

3. System gemäß einem der vorhergehenden Ansprüche, wobei
- ein zu überprüfende Lötkontakt (121, 223) über die interne Diode (111) der BGA-Komponente (110) mit einem ersten Referenzpotential, insbesondere mit Masse, oder mit einem zweiten Referenzpotential, insbesondere mit einer Betriebsspannung der BGA-Komponente, verbunden ist; und
- die Testvorrichtung (200) eingerichtet ist,
- einen ersten Messwert des elektrischen Widerstands einer ersten Verbindungstrecke von dem jeweiligen Messpunkt (201) über den zu überprüfenden Lötkontakt (121, 223) zu dem ersten Referenzpotential zu ermitteln;
- einen zweiten Messwert des elektrischen Widerstands einer zweiten Verbindungstrecke von dem jeweiligen Messpunkt (201) über den zu überprüfenden Lötkontakt (121, 223) zu dem zweiten Referenzpotential zu ermitteln; und
- auf Basis des ersten Messwertes und auf Basis des zweiten Messwertes zu bestimmen, ob der zu überprüfende Lötkontakt (121, 223) einen Defekt aufweist oder nicht.

4. System gemäß Anspruch 3, wobei die Testvorrichtung (200) eingerichtet ist,
- zu bestimmen, dass der zu überprüfende Lötkontakt (121, 223) keinen Defekt aufweist, wenn der erste Messwert oder der zweite Messwert kleiner als ein Widerstands-Schwellenwert sind; und/oder
- zu bestimmen, dass der zu überprüfende Lötkontakt (121, 223) einen Defekt aufweist, wenn der erste Messwert und der zweite Messwert jeweils größer als der Widerstands-Schwellenwert sind.

5. System gemäß einem der vorhergehenden Ansprüche, wobei die Testvorrichtung (200) eingerichtet ist, auf Basis der Mehrzahl von Messwerten als Referenzinformation zu bestimmen, dass
- der Referenz-Lötkontakt (220) defekt ist, wenn alle Messwerte der Mehrzahl von Messwerten größer als ein Widerstands-Schwellenwert sind; und/oder
- der Referenz-Lötkontakt (220) nicht defekt ist, wenn zumindest ein Messwert der Mehrzahl von Messwerten kleiner als der Widerstands-Schwellenwert ist.

6. System gemäß einem der vorhergehenden Ansprüche, wobei
- die interne Diode (111) zwischen einem zu überprüfenden Lötkontakt (121, 223) und dem Referenzpotential in einem Normalbetrieb der BGA-Komponente (110) in Sperrrichtung betrieben wird; und
- die Testvorrichtung (200) ausgebildet ist, ein Spannungspotential an dem Messpunkt (201) anzulegen, um zu bewirken, dass die interne Diode (111) auf der Verbindungstrecke von dem Messpunkt (201) über den zu überprüfenden Lötkontakt (121, 223) und über die interne Diode (111) zu dem Referenzpotential in einem Testbetrieb für die Ermittlung des Messwertes des Widerstands in Durchlassrichtung betrieben wird.

7. System gemäß einem der vorhergehenden Ansprüche, wobei die Testvorrichtung (200) ausgebildet ist, den Messwert des Widerstands während eines Betriebs der BGA-Komponente (110) innerhalb eines elektrischen und/oder elektronischen Geräts zu ermitteln.

8. Verfahren (300) zur Überprüfung eines Lötkontaktes (121, 223) einer auf einer Leiterplatte (100) angeordneten Ball Grid Array, kurz BGA, Komponente (110); wobei die BGA-Komponente (110) einen Referenz-Lötkontakt (222) umfasst, der mit einem Referenzpotential verbunden ist; wobei die BGA-Komponente (110) eine Mehrzahl von Lötkontakten (121, 223) umfasst; wobei die Lötkontakte (121, 223) jeweils über eine interne Diode (111) der BGA-Komponente (110) und über den Referenz-Lötkontakt (222) mit dem Referenzpotential verbunden sind; wobei das Verfahren (300) umfasst,
- Ermitteln (301) einer Mehrzahl von Messwerten eines elektrischen Widerstands einer entsprechenden Mehrzahl von Verbindungstrecken für die entsprechende Mehrzahl von Lötkontakten (121, 223); wobei die Verbindungsstrecke für einen zu überprüfenden Lötkontakt (121, 223) von einem jeweiligen Messpunkt (201) über den jeweils zu überprüfenden Lötkontakt (121, 223), über die jeweilige interne Diode (111) und über den Referenz-Lötkontakt (222) zu dem Referenzpotential verläuft;
- Ermitteln, auf Basis der Mehrzahl von Messwerten, Referenzinformation dahingehend, ob der Referenz-Lötkontakt (222) einen Defekt aufweist oder nicht; und
- Bestimmen (302), auf Basis der Mehrzahl von Messwerten und unter Berücksichtigung der Referenzinformation, ob ein oder mehrere der Mehrzahl von Lötkontakten (121, 223) einen Defekt aufweisen.

## Claims

1. System comprising,
- a ball grid array, BGA, component (110) arranged on a circuit board (100); wherein the BGA component (110) comprises a reference solder contact (222) which is connected to a reference potential; wherein the BGA component (110) comprises a plurality of solder contacts (121, 223); wherein the solder contacts (121, 223) are connected to the reference potential in each case via an internal diode (111) of the BGA component (110) and via the reference solder contact (222); and
- a test apparatus (200) for checking a solder contact (121, 223) of the BGA component (110); wherein the test apparatus (200) is designed,
- to determine a plurality of measured values of an electrical resistance of a corresponding plurality of connecting passages for the corresponding plurality of solder contacts (121, 223); wherein the connecting passages for a solder contact (121, 223) to be checked runs from a respective measuring point (201) to the reference potential via the solder contact (121, 223) to be checked in each case, via the respective internal diode (111) and via the reference solder contact (222);
- to determine reference information on the basis of the plurality of measured values to ascertain whether the reference solder contact (222) has a defect or not; and
- to ascertain on the basis of a plurality of measured values and taking account of the reference information whether one or more of the plurality of solder contacts (121, 223) have a defect.

2. System according to claim 1, wherein the test apparatus (200) is designed,
- to determine whether the determined measured value of the resistance for a solder contact (121, 223) to be checked is greater than or lesser than a predefined resistance threshold value; and
- to ascertain on this basis whether the solder contact (121, 223) to be checked has a defect or not.

3. System according to one of the preceding claims, wherein
- a solder contact (121, 223) to be checked is connected via the internal diode (111) of the BGA component (110) to a first reference potential, in particular to earth, or to a second reference potential, in particular to an operating voltage of the BGA component; and
- the test apparatus (200) is designed,
- to determine a first measured value of the electrical resistance of a first connecting passage from the respective measuring point (201) to the first reference potential via the solder contact (121, 223) to be checked;
- to determine a second measured value of the electrical resistance of a second connecting passage from the respective measuring point (201) to the second reference potential via the solder contact (121, 223) to be checked; and
- to ascertain on the basis of the first measured value and on the basis of the second measured value whether the solder contact (121, 223) to be checked has a defect or not.

4. System according to claim 3, wherein the test apparatus (200) is designed,
- to ascertain that the solder contact (121, 223) to be checked has no defect, when the first measured value or the second measured value are smaller than a resistance threshold value; and/or
- to ascertain that the solder contact (121, 223) to be checked has a defect when the first measured value and the second measured value are each greater than the resistance threshold value.

5. System according to one of the preceding claims, wherein the test apparatus (200) is designed to ascertain on the basis of the plurality of measured values as reference information that
- the reference solder contact (220) is defective when all measured values of the plurality of measured values are greater than a resistance threshold value; and/or
- the reference solder contact (220) is not defective when at least one measured value of the plurality of measured values is lesser than the resistance threshold value.

6. System according to one of the preceding claims, wherein
- the internal diode (111) between a solder contact (121, 223) to be checked and the reference potential is operated in the reverse direction in a normal mode of the BGA component (110); and
- the test apparatus (200) is embodied to apply a voltage potential to the measuring point (201) in order to effect that the internal diode (111) on the connecting passage from the measuring point (201) to the reference potential via the solder contact (121, 223) to be checked and via the internal diode (111) is operated in the forward direction in a test mode for determining the measured value of the resistance.

7. System according to one of the preceding claims, wherein the test apparatus (200) is embodied to determine the measured value of the resistance during operation of the BGA component (110) within an electrical and/or electronic device.

8. Method (300) for checking a solder contact (121, 223) of a ball grid array, BGA, component (110) arranged on a circuit board (100); wherein the BGA component (110) comprises a reference solder contact (222) which is connected to a reference potential; wherein the BGA component (110) comprises a plurality of solder contacts (121, 223); wherein the solder contacts (121, 223) are each connected to the reference potential via an internal diode (111) of the BGA component (110) and via the reference solder contact (222); wherein the method (300) comprises,
- determining (301) a plurality of measured values of an electrical resistance of a corresponding plurality of connecting passages for the corresponding plurality of solder contacts (121, 223); wherein the connecting passage for a solder contact (121, 223) to be checked runs from a respective measuring point (201) to the reference potential via the solder contact (121, 223) to be checked in each case, via the respective internal diode (111) and via the reference solder contact (222);
- determining, on the basis of the plurality of measured values, reference information to ascertain whether the reference solder contact (222) has a defect or not; and
- ascertaining (302) on the basis of the plurality of measured values and taking account of the reference information whether one or more of the plurality of solder contacts (121, 223) have a defect.

## Revendications

1. Système, qui comprend :
- un composant Ball Grid Array (BGA) (110) disposé sur un circuit imprimé (100), dans lequel le composant BGA (110) comprend un contact de soudure de référence (222), qui est relié à un potentiel de référence,
- dans lequel le composant BGA (110) comprend une pluralité de contacts de soudure (121, 223),
- dans lequel les contacts de soudure (121, 223) sont reliés respectivement au potentiel de référence en passant par une diode interne (111) du composant BGA (110) et par le contact de soudure de référence (222), et
- un dispositif de test (200) pour contrôler un contact de soudure (121, 223) du composant BGA (110), dans lequel le dispositif de test (200) est configuré pour :
- identifier une pluralité de valeurs de mesure d'une résistance électrique d'une pluralité correspondante de trajets de liaison pour la pluralité correspondante de contacts de soudure (121, 223),
- dans lequel le trajet de liaison pour un contact de soudure à contrôler (121, 223) s'étend d'un point de mesure (201) respectif jusqu'au potentiel de référence, en passant par le contact de soudure (121, 223) respectif à contrôler, la diode interne respective (111) et le contact de soudure de référence (222),
- identifier, sur la base de la pluralité des valeurs de mesure, des informations de référence indiquant si le contact de soudure de référence (222) présente ou non un défaut, et
- déterminer, sur la base de la pluralité des valeurs de mesure et en tenant compte des informations de référence, si un ou plusieurs de la pluralité des contacts de soudure (121, 223) présentent un défaut.

2. Système selon la revendication 1, dans lequel le dispositif de test (200) est configuré pour:
- identifier si la valeur de mesure identifiée de la résistance pour un contact de soudure (121, 223) à contrôler est supérieure ou inférieure à une valeur seuil de résistance prédéfinie, et
- déterminer, en fonction de cela, si le contact de soudure à contrôler (121, 223) présente un défaut ou non.

3. Système selon l'une des revendications précédentes, dans lequel
- un contact de soudure à contrôler (121, 223) est relié en passant par la diode interne (111) du composant BGA (110) à un premier potentiel de référence, en particulier à une masse, ou à un deuxième potentiel de référence, en particulier à une tension de service du composant BGA, et
- le dispositif de test (200) est configuré pour :
- identifier une première valeur de mesure de la résistance électrique d'un premier trajet de liaison du point de mesure respectif (201) jusqu'au premier potentiel de référence passant par le contact de soudure à contrôler (121, 223),
- identifier une deuxième valeur de mesure de la résistance électrique d'un deuxième trajet de liaison du point de mesure respectif (201) jusqu'au deuxième potentiel de référence passant par le contact de soudure à contrôler (121, 223), et
- déterminer, sur la base de la première valeur de mesure et de la deuxième valeur de mesure, si le contact de soudure à contrôler (121, 223) présente ou non un défaut.

4. Système selon la revendication 3, dans lequel le dispositif de test (200) est configuré pour :
- déterminer que le contact de soudure à contrôler (121, 223) ne présente aucun défaut lorsque la première valeur de mesure ou la deuxième valeur de mesure sont inférieures à une valeur seuil de résistance, et/ou
- déterminer que le contact de soudure à contrôler (121, 223) présente un défaut lorsque la première valeur de mesure et la deuxième valeur de mesure sont respectivement supérieures à la valeur seuil de résistance.

5. Système selon l'une des revendications précédentes, dans lequel le dispositif de test (200) est configuré pour déterminer, sur la base de la pluralité des valeurs de mesure à titre d'informations de référence, que :
- le contact de soudure de référence (220) est défectueux si toutes les valeurs de mesure de la pluralité des valeurs de mesure sont supérieures à une valeur seuil de résistance, et/ou
- le contact de soudure de référence (220) est non-défectueux si au moins une valeur de mesure de la pluralité des valeurs de mesure est inférieure à la valeur seuil de résistance.

6. Système selon l'une des revendications précédentes, dans lequel :
- la diode interne (111) est utilisée dans le sens bloqué, lors d'un fonctionnement normal du composant BGA (110), entre un contact de soudure à contrôler (121, 223) et le potentiel de référence,
- le dispositif de test (200) est configuré pour appliquer un potentiel de tension sur le point de mesure (201) afin d'amener à ce que la diode interne (111) soit utilisée dans le sens passant, dans un fonctionnement d'essai pour déterminer la valeur de mesure de la résistance, sur le trajet de liaison du point de mesure (201) jusqu'au potentiel de référence, en passant par le contact de soudure à contrôler (121, 223) et la diode interne (111).

7. Système selon l'une des revendications précédentes, dans lequel le dispositif de test (200) est configuré pour déterminer la valeur de mesure de la résistance durant un fonctionnement du composant BGA (110) à l'intérieur d'un appareil électrique et/ou électronique.

8. Procédé (300) pour contrôler un contact de soudure (121, 223) d'un composant Ball Grid Array (BGA) (110) disposé sur un circuit imprimé (100), dans lequel le composant BGA (110) comprend un contact de soudure de référence (222), qui est relié à un potentiel de référence,
dans lequel le composant BGA (110) comprend une pluralité de contacts de soudure (121, 223),
dans lequel les contacts de soudure (121, 223) sont reliés respectivement au potentiel de référence via une diode interne (111) du composant BGA (110) et via le contact de soudure de référence (222), dans lequel le procédé (300) comprend :
- l'identification (301) d'une pluralité de valeurs de mesure d'une résistance électrique d'une pluralité correspondante de trajets de liaison pour la pluralité correspondante de contacts de soudure (121, 223),
- dans lequel le trajet de liaison pour un contact de soudure à contrôler (121, 223) s'étend d'un point de mesure (201) respectif jusqu'au potentiel de référence en passant par le contact de soudure à contrôler (121, 223), la diode interne respective (111) et le contact de soudure de référence (222),
- l'identification, sur la base de la pluralité des valeurs de mesure, d'informations de référence indiquant si le contact de soudure de référence (222) présente ou non un défaut, et
- la détermination (302), sur la base de la pluralité des valeurs de mesure et en tenant compte des informations de référence, si un ou plusieurs de la pluralité des contacts de soudure (121, 223) présentent un défaut.
